# EUROPÄISCHE PATENTANMELDUNG

(11) **EP 0 941 020 A2**
(43) Veröffentlichungstag der Anmeldung: **08.09.1999**
(21) Anmeldenummer: 99200506.6
(22) Anmeldetag: 23.02.1999
(51) Int. Cl.: H05K 3/34, H01R 9/09

(54) **Leiterplatte mit SMD-Bauelementen**

(30) Priorität: 04.03.1998 DE 19809138
(71) Anmelder: Philips Patentverwaltung GmbH, 22335 Hamburg (DE); Koninklijke Philips Electronics N.V., 5621 BA Eindhoven (NL)
(72) Erfinder: Matuschik, Peter, Dipl.-Ing., Röntgenstrasse 24, 22335 Hamburg (DE)
(74) Vertreter: Schmalz, Günther, Dipl.-Ing.

(57) **Zusammenfassung**

Die Erfindung betrifft eine Leiterplatte (1) mit mittels eines Reflow-Lötprozesses mit der Leiterplatte (1) elektrisch verbundenen SMD-Bauelementen.

Um eine Leiterplatte zu schaffen, die Anschlußelemente aufweist, deren Montage möglichst kostengünstig ist, wird vorgeschlagen, daß die Leiterplatte (1) ein oder mehrere für eine elektrische Verbindung mit anderen elektrischen Komponenten dienende Anschlußelemente (3a, ..., 3f) aufweist, die in Ausnehmungen der Leiterplatte (1) gelagert sind und nicht nach außen über die Leiterplattenoberfläche, auf der die SMD-Bauelemente befestigt sind, hinausragen.

## Beschreibung

Die Erfindung betrifft eine Leiterplatte mit mittels eines Reflow-Lötprozesses mit der Leiterplatte elektrisch verbundenen SMD-Bauelementen. Die Erfindung betrifft auch ein elektrisches Gerät mit einer solchen Leiterplatte und ein Verfahren zur Herstellung der Leiterplatte.

SMD-Bauelemente sind auf einer Leiterplatte auf deren Oberfläche montierte Bauelemente ("Surface Mounted Device"). Bei der Montage der Leiterplatte wird zunächst Lötpaste mittels eines Siebdruckverfahrens nach einem vorgegebenen Muster auf die Leiterplatte aufgebracht. Anschließend werden die SMD-Bauelemente auf die Leiterplatte aufgesetzt und gegebenenfalls mit einem nichtleitenden Kleber auf der Oberfläche der Leiterplatte fixiert, wobei die Anschlüsse der Bauelemente an vorgegebenen Stellen mit dem auf die Leiterplatte aufgedruckten Lötpastenmuster in Berührung kommen. Die Bauelemente selbst und ihre Anschlüsse befinden sich dabei auf derselben Seite der Leiterplatte. Anschließend wird der sogenannte Reflow-Lötprozess (ein Fließlötvorgang) durchgeführt. Dabei wird das auf die Leiterplatte aufgebrachte Lot durch Wärmezufuhr in einem geeigneten Ofen aufgeschmolzen, so daß feste elektrische Lötverbindungen zwischen den SMD-Bauelementen und der Leiterplatte gebildet werden.

Für das Herstellen von elektrischen Verbindungen mit anderen elektrischen Komponenten, beispielsweise anderen Leiterplatten oder internen Anschlüssen von elektrischen Geräten, sind Anschlußelemente erforderlich. Bekannte Ausführungsformen sehen dabei in Kunststoffblöcke eingelassene Anschlußstifte oder Pinstreifen vor, die nach dem Aufbringen der Lötpaste zusammen mit den SMD-Bauelementen auf die Leiterplatte aufgesetzt werden. Nachteilig ist hier der zusätzliche Platzbedarf auf der Leiterplatte und die zusätzlichen Kosten durch den verwendeten Kunststoff, der sich bei den hohen Temperaturen während des Reflow-Lötprozesses nicht verflüssigen darf. Gerade bei einer Massenproduktion sind die zusätzlichen Kosten nicht unerheblich. Als Alternative hierzu ist es bekannt, separate Anschlußelemente (z. B. Anschlußstifte) zu verwenden, die erst nach dem Reflow-Lötprozeß per Hand auf die Leiterplatte aufgelötet werden, was zusätzliche Arbeitskosten verursacht.

Der Erfindung liegt die Aufgabe zugrunde, eine Leiterplatte zu schaffen, die Anschlußelemente aufweist, deren Montage möglichst kostengünstig ist.

Die Aufgabe wird dadurch gelöst, daß die Leiterplatte ein oder mehrere für eine elektrische Verbindung mit anderen elektrischen Komponenten dienende Anschlußelemente aufweist, die in Ausnehmungen der Leiterplatte gelagert sind und nicht nach außen über die Leiterplattenoberfläche, auf der die SMD-Bauelemente befestigt sind, hinausragen.

Die Montage der Anschlußelemente, die insbesondere als Anschlußstifte ausgebildet sind, kann auf diese Weise in den automatisierten Herstellungsprozeß der Leiterplatte integriert werden. Die Anschlußelemente werden so in der Leiterplatte angeordnet, daß ein Aufbringen der Lötpaste zwischen den Anschlußelementen und der Leiterplatte mittels Siebdruckes möglich ist. Dies läßt sich insbesondere dadurch realisieren, daß die Anschlußelemente nicht nach außen über die Leiterplattenoberfläche, auf der die SMD-Bauelemente befestigt sind, hinausragen.

Werden die Anschlußelemente in einem Randbereich der Leiterplatte angeordnet, kann die Leiterplatte besonders einfach durch im Randbereich erzeugte Ausnehmungen für die Aufnahme und Lagerung der Anschlußelemente ausgestaltet werden. Derartige Ausnehmungen lassen sich beispielsweise in Stanz- oder Fräsvorgängen erzeugen. Um einen festen Sitz der Anschlußelemente schon vor und während des Lötprozesses zu gewährleisten, werden die Anschlußelemente in die Ausnehmungen eingepreßt, was in einem automatisierten Vorgang durchgeführt werden kann.

Die Erfindung betrifft auch ein elektrisches Gerät mit einer erfindungsgemäßen Leiterplatte. Beispielsweise kann die Leiterplatte in elektrischen Geräten der Unterhaltungselektronik eingesetzt werden. Jedoch ist der Anwendungsbereich nicht auf eine derartige Anwendungen beschränkt. Vorzugsweise wird die erfindungsgemäße Leiterplatte in in Massenproduktion hergestellten elektrischen Geräten zum Einsatz gelangen.

Die Erfindung betrifft auch ein Verfahren zur Herstellung einer Leiterplatte mit SMD-Bauelementen, die mittels eines Reflow-Lötprozesses mit der Leiterplatte elektrisch verbunden werden, bei dem vor dem Aufbringen der für den Reflow-Lötprozeß verwendeten Lötpaste ein oder mehrere für eine elektrische Verbindung mit anderen elektrischen Komponenten dienende Anschlußelemente an der vorgesehenen Stelle in der Leiterplatte angeordnet werden Danach werden die Anschlußelemente mittels des Reflow-Lötprozesses mit der Leiterplatte verbunden. Die mit diesem Herstellungsverfahren erzielbaren Vorteile ergeben sich aus den obigen Ausführungen.

Ausführungsbeispiele der Erfindung werden im folgenden anhand der Figuren näher beschrieben. Es zeigen:

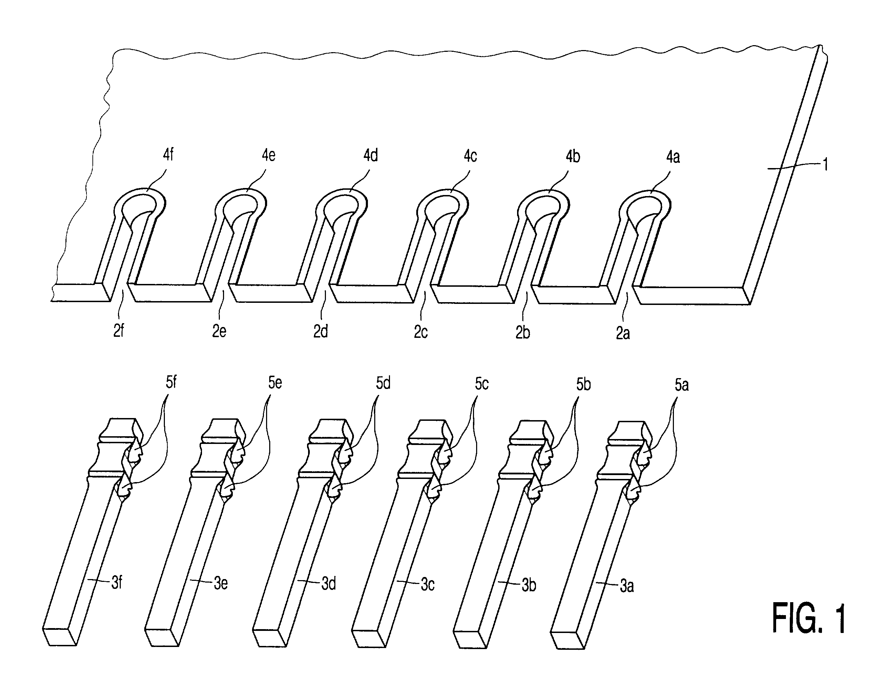

- Fig. 1: eine Leiterplatte mit Anschlußelementen im nicht in die Leiterplatte Zustand und

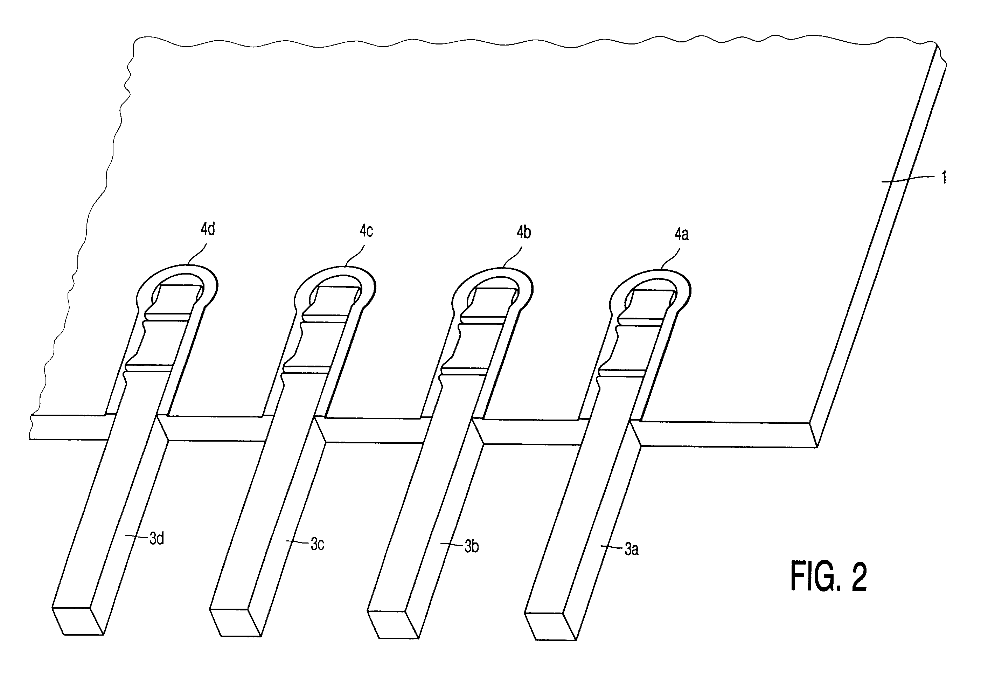

- Fig. 2: die Ausführungsform nach Fig. 1 mit in die Leiterplatte eingesetzten Anschlußelementen.

Die in den Figuren gezeigte Leiterplatte 1 dient zur Aufnahme von nicht gezeigten SMD-Bauelementen, um eine elektrische Schaltung zu realisieren. Es ist nur ein Ausschnitt der Leiterplatte 1 dargestellt, da dies zur Beschreibung der Erfindung ausreicht. Im unteren Randbereich der Leiterplatte 1 sind Ausnehmungen 2a, 2b, ..., 2fvorgesehen, die zur Aufnahme von als Anschlußstifte ausgebildeten Anschlußelementen 3a, 3b, ..., 3f dienen. Die Ausnehmungen 2a bis 2f bestehen aus vom unteren Rand der Leiterplatte 1 sich senkrecht in das Leiterplatteninnere erstreckenden Schlitzen, die an ihren im Inneren der Leiterplatte 1 liegenden Enden in in die Leiterplatte 1 eingebrachte Löcher übergehen. Die Ausnehmungen 2a bis 2f werden beispielsweise durch einen Stanzvorgang erzeugt. Sie können aber auch dadurch erhalten werden, daß die Schlitze der Ausnehmungen in die Leiterplatte 1 gefräst und die Löcher mittels eines Bohr- oder Stanzvorganges erzeugt werden.

Die Anschlußelemente 3a bis 3f dienen zum Herstellen einer elektrischen Verbindung mit anderen elektrischen Komponenten, die nicht dargestellt sind, beispielsweise anderen Komponenten (z.B. Leiterplatten) eines elektrischen Gerätes.

Bei der Herstellung der Leiterplatte 1 werden in einem ersten Arbeitsvorgang zunächst die Ausnehmungen 2a bis 2f wie oben beschrieben in die Leiterplatte 1 eingebracht. Die Ausnehmungen 2 a bis 2f sind im angrenzenden Bereich der Leiterplatte 1 mit elektrisch leitfähigen Beschichtungen 4a bis 4f (beispielsweise aus Kupfer) versehen, um einen sicheren elektrischen Kontakt zu den Anschlußelementen 3a bis 3f zu gewährleisten. In die Ausnehmungen 2a bis 2f werden nun die Anschlußelemente 3a bis 3f in einem automatisierten Vorgang eingepreßt. Um einen sicheren Halt der Anschlußelemente 3a bis 3f in den Ausnehmungen 2a bis 2f zu gewährleisten, weisen die Anschlußstifte Verbreiterungen 5a bis 5f auf, die sich bei Einpreßvorgang in die Leiterplatte eindrücken. Um den festen Sitz der Anschlußelemente 3a bis 3f noch zu verstärken, kann sich noch ein Einstemmvorgang anschließen, bei dem die Anschlußelemente 3a bis 3f im Bereich der Verbreiterungen 5a bis 5f eingekerbt werden.

In einem zweiten Verfahrensschritt wird nun im Siebdruckverfahren in üblicher Weise ein Lötpastenmuster auf die Leiterplatte 1 aufgedruckt. Dabei wird auch im Randbereich der Ausnehmungen 2a bis 2f Lötpaste auf die Leiterplatte 1 aufgebracht, so daß eine elektrische Verbindung der Anschlußstifte 3a bis 3f mit durch die Lötpaste zu erzeugenden Leiterbahnen gewährleistet werden kann. Da die Anschlußelemente 3a bis 3f nicht über die Leiterplattenoberfläche nach außen hin hinausragen, kann der Siebdruck des Lötpastenmusters mit in die Leiterplatte 1 eingesetzten Anschlußelementen 3a bis 3f erfolgen.

In einem dritten Verfahrensschritt erfolgt das Aufsetzen von SMD-Bauelementen auf die Leiterplatte 1. Um einen sicheren Halt der Bauelemente auf der Leiterplatte 1 für die folgende Weiterverarbeitung der Leiterplatte 1 zu gewährleisten, wird vorzugsweise eine Verklebung der Bauelemente mit der Leiterplatte 1 durchgeführt.

In einem vierten Verfahrensschritt wird schließlich die Leiterplatte 1 in einen Ofen eingeführt. Der Ofen ist üblicherweise auf Temperaturen über 240 °C erhitzt. Durch die zugeführte Wärmeenergie wird das in der Lötpaste enthaltene Lot aufgeschmolzen. Dabei entsteht in üblicher Weise eine Schaltungsstruktur auf der Leiterplatte 1. Bei der erfindungsgemäßen Leiterplatte 1 werden nun außerdem die Lötverbindungen zwischen den Anschlußelementen 3a bis 3f und der auf der Leiterplatte 1 entstandenen Schaltungsstruktur hergestellt. Das Lot der im Randbereich der Ausnehmungen 4a bis 4f aufgedruckten Lötpaste fließt dabei in die Zwischenräume zwischen den Anschlußelementen 3a bis 3f und den die Ausnehmungen 4a bis 4f abgrenzenden Leiterplattengrenzflächen, auf die die Beschichtungen 4a bis 4f aufgebracht sind.

## Patentansprüche

1. Leiterplatte (1) mit mittels eines Reflow-Lötprozesses mit der Leiterplatte (1) elektrisch verbundenen SMD-Bauelementen,
dadurch gekennzeichnet,
daß die Leiterplatte (1) ein oder mehrere für eine elektrische Verbindung mit anderen elektrischen Komponenten dienende Anschlußelemente (3a, ..., 3f) aufweist, die in Ausnehmungen der Leiterplatte (1) gelagert sind und nicht nach außen über die Leiterplattenoberfläche, auf der die SMD-Bauelemente befestigt sind, hinausragen.

2. Leiterplatte nach Anspruch 1,
dadurch gekennzeichnet,
daß die Anschlußelemente (3a, ..., 3f) in einem Randbereich der Leiterplatte (1) angeordnet sind.

3. Leiterplatte nach Anspruch 1 oder 2,
dadurch gekennzeichnet,
der die Anschlußelemente (3a, ..., 3f) in einem ausgestanzten oder ausgefrästen Bereich der Leiterplatte (1) gelagert sind.

4. Leiterplatte nach einem der Ansprüche 1 bis 3,
dadurch gekennzeichnet,
daß die Anschlußelemente (3a, ..., 3f) als Anschlußstifte ausgebildet sind.

5. Elektrisches Gerät mit einer Leiterplatte (1) nach einem der Ansprüche 1 bis 4.

6. Verfahren zur Herstellung einer Leiterplatte (1) mit SMD-Bauelementen, die mittels eines Reflow-Lötprozesses mit der Leiterplatte (1) elektrisch verbunden werden,
dadurch gekennzeichnet,
daß vor dem Aufbringen der für den Reflow-Lötprozeß verwendeten Lötpaste ein oder mehrere für eine elektrische Verbindung mit anderen elektrischen Komponenten dienende Anschlußelemente (3a, ..., 3f) an der vorgesehenen Stelle in der Leiterplatte (1) angeordnet werden und
daß die Anschlußelemente (3a, ..., 3f) mittels des Reflow-Lötprozesses mit der Leiterplatte (1) verbunden werden.
